# EUROPEAN PATENT APPLICATION

(11) **EP 4 769 938 A1**
(43) Date of publication of application: **01.07.2026**
(21) Application number: 24315603.1
(22) Date of filing: 24.12.2024
(51) Int. Cl.: H02S 20/10, H02S 40/22, H10F 77/00

(54) **PHOTOVOLTAIC EQUIPMENT AND PHOTOVOLTAIC STRUCTURE**

(71) Applicant: TOTALENERGIES ONETECH, 92400 Courbevoie (FR)
(72) Inventor: CHAPON, Julien, 92400 COURVEVOIE (FR); RABOIN, Jean - Christophe, 92400 COURVEVOIE (FR)
(74) Representative: Innovincia

(57) **Abstract**

The present invention refers to a photovoltaic equipment (10) comprising:
- a carrying structure (11),
- at least one photovoltaic module (13) arranged sensibly vertically on the carrying structure (11),
- at least one reflective surface (17) with a top side arranged on the carrying structure (11) below the, at least one, photovoltaic module (13),
wherein the angle between the reflective surface (17) and the photovoltaic module (13) is higher than 90°.

## Description

### Background of the invention

The field of the present invention refers to the photovoltaic equipment destined to be implemented in a solar farm, for example in a field for an agrivoltaic application or in desertic areas.

Solar farms comprise large areas wherein a large number of photovoltaic modules are distributed.

One concern of the solar farm is to prevent the soiling of the photovoltaic modules as such soiling leads to significant losses of photovoltaic yield. Furthermore, due to the high number of photovoltaic modules, a cleaning device of the photovoltaic modules is hard to implement.

In order to limit the soiling of the photovoltaic panels, it is known to arrange the photovoltaic modules vertically. However, the vertical arrangement of the photovoltaic modules tends to reduce the photovoltaic energy production, especially when the sun is close to its zenith during median hours of the day.

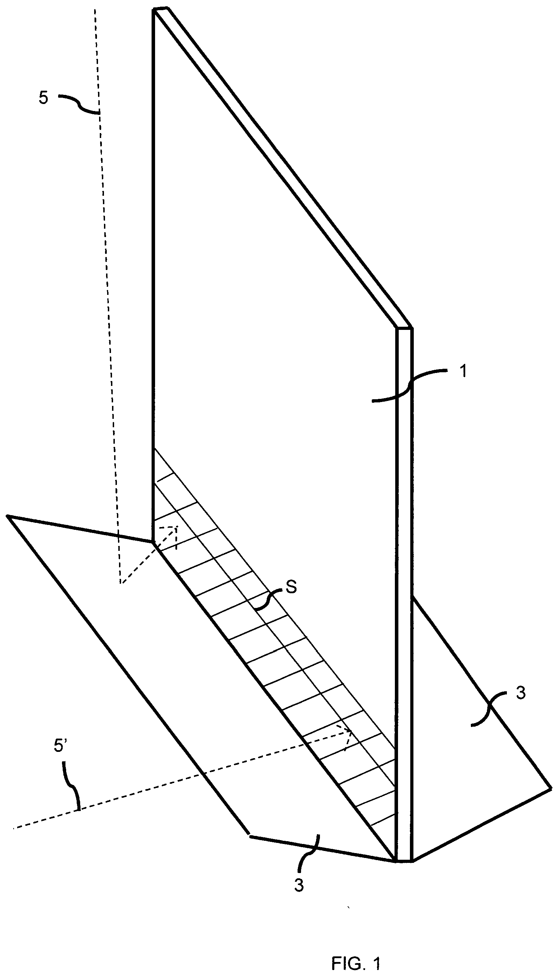

One way to overcome this loss of yield during median hours is to arrange a reflective surface 3, such as a bright surface or a mirror, on the floor next to the photovoltaic module 1, the reflective surface 3 being tilted towards the photovoltaic module 1 to reflect the sun rays 5 towards the photovoltaic module 1 as represented in Fig. 1.

However, with such arrangement, the reflective surface 3 introduce a shadow (corresponding to the zone below the line S) on the lower part of the photovoltaic module 1 when the sun is low as represented by the sun ray 5', that is to say after sunrise or before sunset. Furthermore, the reflective surface 3 produces a concentration of light in the bottom region of the photovoltaic module 1 represented by the striped region when the sun is close to its zenith which leads to the creation of hotspots in this stripped region. Such hotspots may lead to a reduction of the photovoltaic yield as well as a faster ageing of the photovoltaic module 1.

It is therefore an object of the present invention to overcome the above-mentioned drawbacks of the state of the art and to offer a solution providing a photovoltaic equipment with a global enhanced photovoltaic yield with a limited maintenance.

### Summary of the invention

The present invention refers to a photovoltaic equipment comprising:
- a carrying structure,
- at least one photovoltaic module arranged sensibly vertically on the carrying structure,
- at least one reflective surface with a top side arranged on the carrying structure below the, at least one, photovoltaic module,
wherein the angle between the reflective surface and the photovoltaic module is larger than 90°.

The use of a vertical photovoltaic module which is raised above reflective surface that are arranged with an angle larger than 90° enables limiting the soiling of the photovoltaic module. Furthermore, the reflective surfaces are configured to reflect sun rays towards neighboring photovoltaic modules in order to enhance the photovoltaic yield of the neighboring photovoltaic modules.

According to another aspect of the present invention, the at least one photovoltaic module is a bifacial photovoltaic module and at least one reflective surface is arranged on one side of the bifacial photovoltaic module and at least one reflective surface is arranged on the other side of the bifacial photovoltaic module.

According to another aspect of the present invention, the reflective surface is a diffuse reflective surface.

According to another aspect of the present invention, the reflective surface is a Lambertian surface.

According to another aspect of the present invention, the reflective surface is made of a flexible or soft material which is drawn tight between the carrying structure and the ground.

According to another aspect of the present invention, the reflective surface is made of non-woven polypropylene.

According to another aspect of the present invention, the angle between the reflective surface and the photovoltaic module is comprised in a range from 120° to 150°.

The present invention also refers to a photovoltaic structure comprising a plurality of photovoltaic equipment as described previously which are arranged as a row and wherein the carrying structure comprises a plurality of vertical posts configured to be arranged between two adjacent photovoltaic modules and configured to be partially buried in the ground.

According to another aspect of the present invention, the photovoltaic structure comprises a plurality of rows of photovoltaic equipment arranged parallel to each other and the at least one reflective surface associated with the photovoltaic modules of a row is configured to reflect sun rays towards the photovoltaic modules of the adjacent row.

According to another aspect of the present invention, the rows are oriented according to a south-north axis.

### Brief description of the drawings

[Fig.1] is a diagram of a photovoltaic equipment with a vertical photovoltaic module and reflective surfaces according to the state of the art;
[Fig.2] is a diagram of a photovoltaic equipment according to an embodiment of the present invention;
[Fig.3] is a diagram of a carrying structure according to an embodiment of the present invention;
[Fig.4] is a diagram of a carrying structure according to another embodiment of the present invention;
[Fig.5] is a diagram of a photovoltaic structure according to an embodiment of the present invention;

### Detailed description of the invention

The following achievements are examples. Although the specification refers to one or several embodiments, it does not imply that each reference refers to the same embodiment or that the features apply only to a single embodiment. Simple features of different embodiments can also be combined to provide other embodiments.

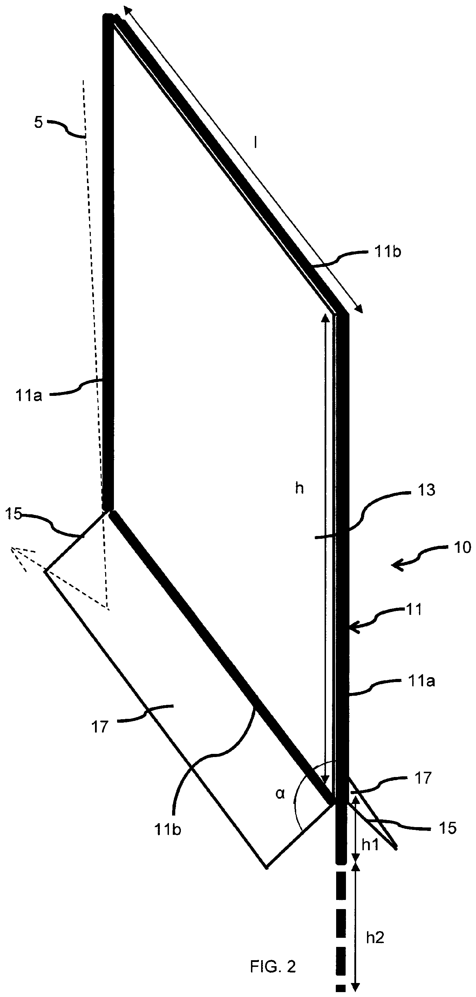

Fig.2 represents a photovoltaic equipment 10 according to an embodiment of the present invention.

The photovoltaic equipment 10 comprises at least one photovoltaic module 13 configured to be arranged sensibly vertically. The photovoltaic module 13 may be a bifacial photovoltaic module 13 configured for receiving sunlight on both of its sides. Alternatively, two (monofacial) photovoltaic modules 13 may be arranged back-to-back to provide a photovoltaic equipment 10 configured for converting sun rays coming from both sides into electricity.

The photovoltaic equipment 10 may be arranged so that the photovoltaic module 13 is oriented according to a north-south direction, that is to say, one side of the bifacial photovoltaic module 13 is oriented towards the east (and is configured to provide electrical energy mostly in the morning) and the other side of the bifacial photovoltaic module 13 is oriented towards the west (and is configured to provide electrical energy mostly in the afternoon).

The photovoltaic equipment 10 also comprises a carrying structure 11 configured for carrying the at least one photovoltaic module 13. The carrying structure 11 may be in the form of a frame surrounding the at least one photovoltaic module 13 with two vertical posts 11a configured to be partially buried into the ground (as represented by the dotted line) and two horizontal bars 11b linking the vertical posts 11a. The vertical posts 11a may be buried of a height h2 comprised between 20cm and 2m. Alternatively, the vertical posts 11a may not be buried. In such case, either the carrying structure 11 is only laid down on the ground or other parts of the carrying structure 11 are partially buried into the ground such as stakes configured to be introduced in holes of the bottom part of the carrying structure 11, or alternatively, in an embodiment not shown in the figure, the lower parts of vertical posts 11a, which correspond to section h1 are at least in part connected or embedded in a counterweight, which can be made of e.g. concrete, stone and/or metal. The material, the shape of the cross section and the diameter (or size) of the vertical posts 11a and horizontal bars 11b may be chosen according to the required stiffness for the carrying structure 11. The material of the horizontal bars 11b and vertical posts 11a may be stainless steel. The carrying structure 11 is configured to raise the photovoltaic panel to a height h1 comprised between 20cm and 2m.

Other architectures of the carrying structure 11 are also possible, for example a carrying structure 11 comprising only vertical posts 11a. The carrying structure 11 may also comprise inclined panels 15 with a bottom side lying on the ground and a top side linked to the vertical posts 11a and/or to the horizontal bar 11b arranged at the bottom of the photovoltaic module 13. An inclined panel 15 is arranged on each side of the photovoltaic equipment 10.

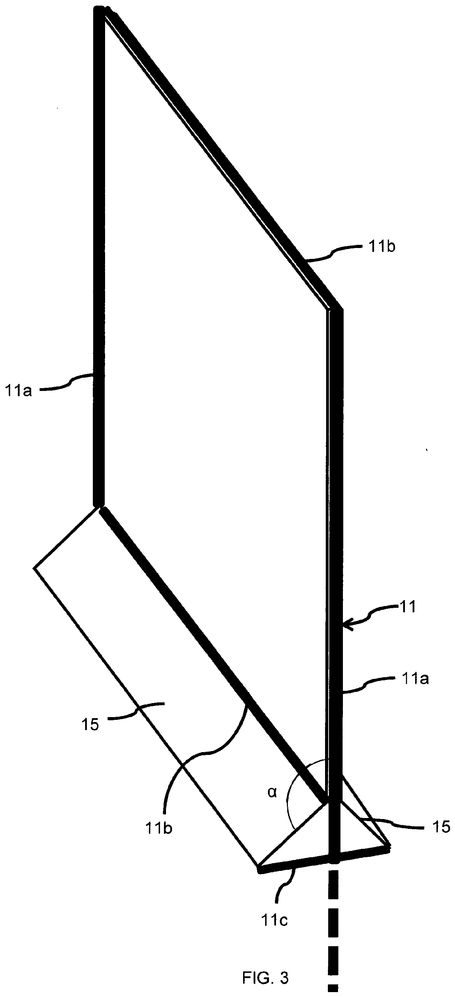

According to an embodiment of the carrying structure 11 represented in Fig.3, the carrying structure 11 also comprises linking bars 11c, for example one at each edge of the photovoltaic equipment 10, configured to link the bottom side of both inclined panels 15 (one on each side of the photovoltaic equipment 10) to increase the stiffness of the carrying structure 11. The linking bars 11c may be of the same material as the vertical posts 11a and the horizontal bars 11b.

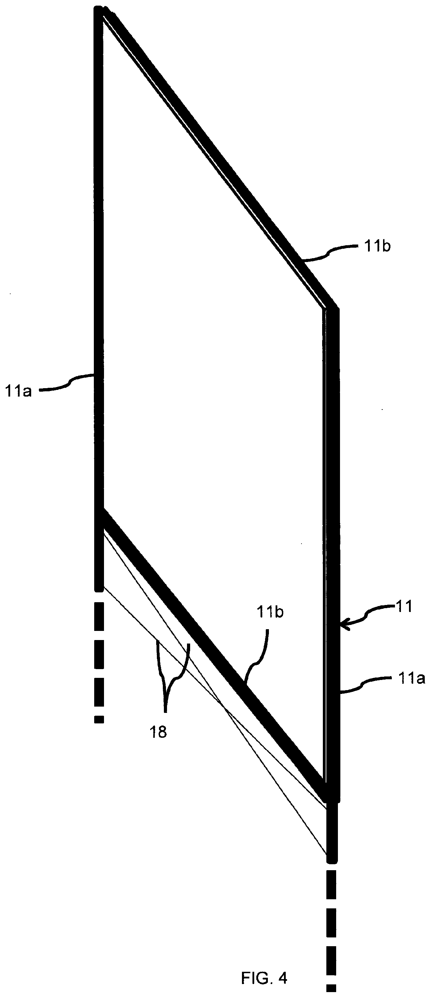

According to another embodiment of the carrying structure 11 represented in Fig.4, the carrying structure 11 may also comprise reinforcing longitudinal elements 18 linking two vertical posts 11a. The reinforcing longitudinal elements 18 are positioned below the photovoltaic module 10 and may be implemented as rigid elements such as rods, for example metal rods (which may be made of the same material as the vertical posts 11a and the horizontal bars 11b) or as tensioned elements such as cables, tendons or ropes. According to the embodiment of Fig.4, two reinforcing longitudinal elements 18 crossing each other are arranged between two vertical posts 11a but other arrangements may also be used.

The different embodiments of the carrying structure 11 presented previously may be combined to provide other embodiments according to the desired stiffness of the carrying structure 11.

The carrying structure 11 is configured to hold the at least one photovoltaic module 13 at a predetermined height h1 comprised for example between 20cm and 1m. The height h and the length 1 of the photovoltaic module 13 may be comprised between 50cm and 2m. When the photovoltaic module 13 is of rectangular shape, it can be installed within the carrying structure 11 in landscape or portrait position. Several photovoltaic modules 13 may be superimposed (one on top of the other) on the carrying structure 11.

The photovoltaic equipment 10 also comprises at least one reflective surface 17 with a top side arranged on the carrying structure 11 below the photovoltaic module 13. The reflective surface 17 may be arranged on the inclined panels 15 as represented in Fig.2. Preferably, the reflective surface 17 is a diffuse reflective surface, more specifically a Lambertian surface wherein the reflection is the same in all the directions. The reflective surface 17 may be made of a metal plate which can be painted or an expanded metal sheet. The metal may be steel or aluminum for example. The reflective surface 17 may be a matte surface in order to provide a diffuse reflection. Such a matte aspect may be obtained by chemical process (anodizing for aluminum, galvanizing or chromating for steel or mechanical process (sanding, shot blasting for aluminum or stainless steel). Alternatively or in addition, the metal sheets may be coated with matte paint or matte varnish or may be powder coated.

The metal sheet may be massive, perforated or deployed. Perforated or deployed metal sheets enable controlling the flow of dusts and water to ease the cleaning and reduce the soiling at the bottom of the metal sheets. Such embodiments may be particularly useful in desertic (without rains) or tropical (with heavy rains) regions.

The reflective surface 17 may also be made of a soft material which is stretched between the ground and the bottom of the photovoltaic module 13, for example drawn tight between the carrying structure 11 (in particular the bottom horizontal bar 11b) and the ground. The soft material may also be arranged above an inclined panel 15, for example glued to the inclined panel 15 or pinched between the lower horizontal bar 11b and the photovoltaic module 13. The lower horizontal bar 11b is the horizontal bar 11b that is the closest to the ground. The soft material may be a broad spectral band light reflective fabric such as a polymer fabric, such as a non-woven polypropylene (PP) fabric or a non-woven polyethylene (PE) fabric, for example the non-woven PE fabric manufactured by the DuPont company under trademark Tyvek^{™}. It is desirable that the non-woven polypropylene or non-woven polyethylene fabric is resistant to UV degradation thanks to adjunction of a UV degradation inhibitor such as a HALS within the polymer. HALS stands for Hindered Amine Light Stabilizer. HALS additive that can be appropriate for protection against UV degradation is any commercial HALS product or composition. A part of the soft material may be buried into the ground to hold it in position
The reflective surface 17 is arranged such that the angle α between the reflective surface 17 and the photovoltaic module 13 is higher than 90°, for example comprised between 120° and 150°. As a consequence, a sun ray 5 closed to the vertical direction is reflected away from the photovoltaic module 13 arranged above the reflective surface 17 as represented in Fig.2.

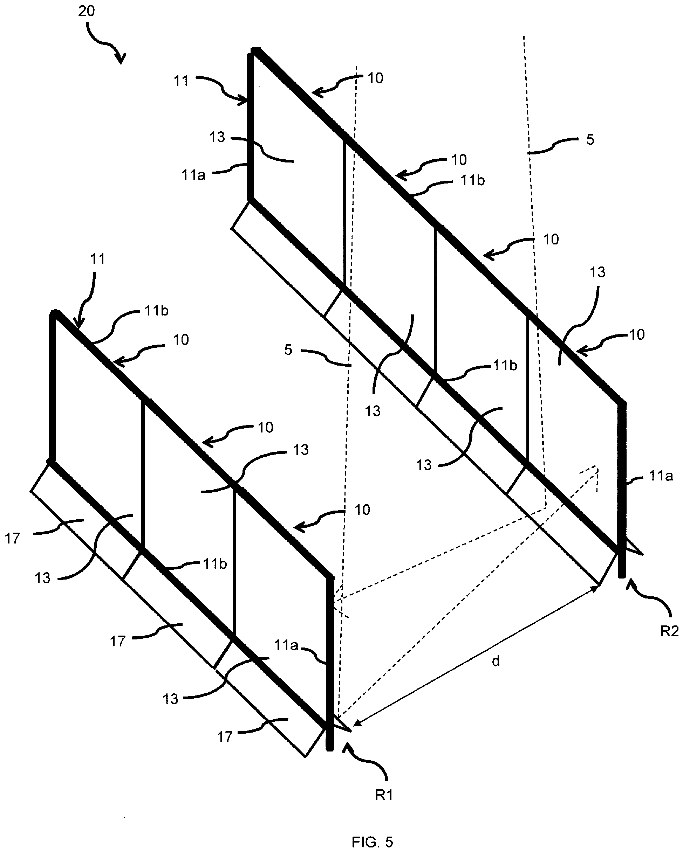

The present invention also refers to a photovoltaic structure 20 comprising a plurality of photovoltaic equipment 10 as described previously. Fig.5 represents an example of such a photovoltaic structure 20.

The photovoltaic equipment 10 may be aligned to form a row and the photovoltaic structure 20 may comprise a plurality of rows arranged parallel to each other. In the example of Fig.5, the photovoltaic structure 20 comprises a first row noted R1 and a second row noted R2 arranged next to the first row R1 (in practice the rows may comprise tens or hundreds of photovoltaic equipment and tens or hundreds of parallel rows may be distributed in the solar farm). The distance d between the first row R1 and the second row R2 is for example comprised between 5m and 10m. Preferably, the rows R1, R2 may be oriented according to a north-south direction as indicated above for the orientation of a photovoltaic equipment 10.

Within a row, a single carrying structure 11 may be used to hold a plurality of photovoltaic modules 13 of the row so that a single vertical post 11a may be used between two adjacent photovoltaic modules 13 and two horizontal bars 11b linking the different vertical posts 11a may be used along the plurality of photovoltaic modules 13 of the row.

The reflective surfaces 17 may be configured to reflect a sun ray closed to the vertical direction (corresponding to a sun closed to its zenith) towards one or several photovoltaic modules 13 of an adjacent row as represented by the sun rays 5 in Fig.5. Thus, a sun ray reaching a reflective surface 17 of the first row R1 located on the side of the second row R2 may be reflected towards one or several photovoltaic modules 13 of the second row R2 while a sun ray 5 reaching a reflective surface 17 of the second row R2 located on the side of the first row R1 may be reflected towards one or several photovoltaic modules 13 of the first row R1.

As the reflective surfaces 17 are diffuse reflective surfaces, the sun rays 5 are reflected towards a large surface of the photovoltaic module(s) of the adjacent row which prevents the creation of hotspots due to the reflected sun rays. Similarly, as reflective surfaces 17 are diffuse reflective surfaces, they may be flat or curved without significantly altering their overall performance.

Thus, by providing a photovoltaic equipment 10 and a photovoltaic structure 20 with reflective surface 17 arranged below the photovoltaic module 13 with an angle higher than 90°, the present invention avoids the creation of a shadow region at the bottom of the photovoltaic module 13 due to the presence of the reflective surface 17, notably when the sun is low (at sunrise and sunset). Moreover, as the photovoltaic modules are vertical and are raised above the reflective surfaces 17, the soiling of the photovoltaic modules 13 is largely reduced. It is to be noted that, in case the reflective surface is flexible, it may be sensitive to wind, the latter being responsible for vibrations of the reflective surface 17, resulting in reduction of soiling by improvement of sliding of soiling particles down to the ground. Furthermore, when the photovoltaic structure 20 comprises a plurality of aligned photovoltaic equipment 10 to form a plurality of parallel rows R1, R2, the reflective surfaces 17 of a row are configured to reflect sun rays towards the photovoltaic module 13 of the adjacent row which leads to an increase of the energy conversion yield of the photovoltaic structure 20, notably during median hours (when the sun is closed to its zenith).

## Claims

1. Photovoltaic equipment (10) comprising:
- a carrying structure (11),
- at least one photovoltaic module (13) arranged sensibly vertically on the carrying structure (11),
- at least one reflective surface (17) with a top side arranged on the carrying structure (11) below the, at least one, photovoltaic module (13),
wherein the angle between the reflective surface (17) and the photovoltaic module (13) is higher than 90°.

2. Photovoltaic equipment (10) according to claim 1 wherein the at least one photovoltaic module (13) is a bifacial photovoltaic module (13) and wherein at least one reflective surface (17) is arranged on one side of the bifacial photovoltaic module (13) and at least one reflective surface (17) is arranged on the other side of the bifacial photovoltaic module (13).

3. Photovoltaic equipment (10) according to claim 1 or 2 wherein the reflective surface (17) is a diffuse reflective surface.

4. Photovoltaic equipment (10) according to the previous claim wherein the reflective surface (17) is a Lambertian surface.

5. Photovoltaic equipment (10) according to one of the previous claims wherein the reflective surface (17) is made of a flexible or soft material which is drawn tight between the carrying structure (11) and the ground.

6. Photovoltaic equipment (10) according to the previous claim wherein the reflective surface (17) is made of non-woven polypropylene.

7. Photovoltaic equipment (10) according to one of the previous claims wherein the angle (α) between the reflective surface (17) and the photovoltaic module (13) is comprised in a range from 120° to 150°.

8. Photovoltaic structure (20) comprising a plurality of photovoltaic equipment (10) according to one of the previous claims arranged as a row (R1, R2) and wherein the carrying structure (11) comprises a plurality of vertical posts (11a) configured to be arranged between two adjacent photovoltaic modules (13) and configured to be partially buried in the ground.

9. Photovoltaic structure (20) according to the previous claim wherein the photovoltaic structure comprises a plurality of rows (R1, R2) of photovoltaic equipment (10) arranged parallel to each other and wherein the at least one reflective surface (17) associated with the photovoltaic modules (13) of a row is configured to reflect sun rays towards the photovoltaic modules (13) of the adjacent row (R1, R2).

10. Photovoltaic structure (20) according to the previous claim wherein the rows (R1, R2) are oriented according to a south-north axis.
